Europäisches Patentamt

(19) European Patent Office

Office européen des brevets

(11) Numéro de publication: **0 198 376**
A1

(12) **DEMANDE DE BREVET EUROPEEN**

(21) Numéro de dépôt: 86104689.4

(22) Date de dépôt: 05.04.86

(51) Int. Cl.⁴: **H 01 L 23/48**, G 06 K 19/06

(30) Priorité: 10.04.85 CH 1529/85
02.05.85 FR 8506819

(43) Date de publication de la demande: 22.10.86
Bulletin 86/43

(84) Etats contractants désignés: AT CH DE FR GB IT LI NL
SE

(71) Demandeur: EM Microelectronic-Marin SA,
CH-2074 Marin (CH)

(72) Inventeur: Alain, Juan, Chemin des Esserts 30,
CH-2054 Chézard (CH)

(74) Mandataire: Barbeaux, Bernard et al, SMH Société
Suisse de Microélectronique et d'Horlogerie S.A.
Département Brevets et Licences 6, Faubourg du Lac,
CH-2501 Bienne (CH)

(54) Unité électronique notamment pour carte à microcircuits et carte comprenant une telle unité.

(57) L'invention a pour objet une unité électronique de petites dimensions utilisable notamment pour la fabrication de cartes à microcircuits.

Dans cette unité qui comprend un support (8, 9) susceptible d'être soumis à des contraintes pouvant entraîner sa déformation, une puce de circuit intégré (1) et un ensemble de conducteurs (5) ayant chacun une extrémité à laquelle est fixée une borne de connexion (2) de la puce et une autre liée rigidement au support, la puce est montée sur une feuille souple de matériau isolant (3) sur laquelle est fixée au moins une portion de chacun des conducteurs, qui est portée par le support directement ou par l'intermédiaire de ces conducteurs et dont au moins une fraction qui comprend la zone dans laquelle se trouve la puce et une majeure partie de l'entourage de celle-ci est dépourvue de toute liaison rigide avec ce support.

La feuille souple dispose ainsi d'une certaine liberté qui lui permet de ne pas suivre ou de ne suivre que partiellement les mouvements du support lorsqu'il subit effectivement des déformations, ce qui permet d'éviter au moins en grande partie que les contraintes auxquelles il est alors soumis soient transmises non seulement aux liaisons entre les bornes de la puce et les conducteurs mais aussi aux conducteurs eux-mêmes.

Applications aux cartes de crédit, cartes de parking, cartes de paiement pour des appels téléphoniques etc.

0198376

Cas 419
BB/ab

# UNITE ELECTRONIQUE NOTAMMENT POUR CARTE A MICROCIRCUITS ET CARTE COMPRENANT UNE TELLE UNITE

La présente invention a pour objet une unité électronique de petites dimensions destinée plus particulièrement à des cartes à microcircuits telles que cartes de crédit, cartes bancaires, cartes de parking, cartes de paiement pour des appels téléphoniques dans des cabines publiques, etc., car c'est dans ce domaine qu'elle est actuellement la plus utile, mais qui peut trouver aussi d'autres applications, par exemple dans des appareils de petite dimension où une cellule d'affichage est commandée par un circuit intégré ou dans le domaine de la construction automobile où l'on envisage d'introduire dans des liaisons électriques qui permettent d'alimenter certains éléments d'un véhicule, tels que les phares, des microprocesseurs périphériques reliés à un mini-ordinateur central et chargés de commander et de surveiller le fonctionnement de ces éléments.

Telles qu'elles sont connues actuellement, les unités électroniques destinées à équiper des cartes de transactions se présentent généralement sous la forme d'une pastille prévue pour être incorporée dans une ouverture correspondante du corps de carte située dans un coin de celui-ci et comportant une mémoire et un microprocesseur intégrés sous forme d'une seule puce ou de deux puces connectées entre elles par des conducteurs électriques, un ensemble de plages de contact, souvent au nombre de huit, reliées uniquement au microprocesseur et un corps isolant dans lequel sont noyés tous les autres éléments à l'exception naturellement des plages conductrices qui doivent rester accessibles pour les pièces de connexion d'un appareil, par exemple un terminal d'ordinateur, dans lequel la carte est destinée à être introduite. Dans certains cas, ce corps isolant qui définit la forme de la pastille et qui assure la protection des éléments qu'il entoure se compose d'une partie support et d'une partie couverture, dans d'autres il s'agit d'un enrobage homogène.

D'autre part, indépendamment des questions liées au circuit intégré lui-même, comme par exemple celles de savoir quelles informations la mémoire doit contenir, quelles fonctions doit remplir le microprocesseur, de quelle façon doivent être conçus cette mémoire et ce microprocesseur, la réalisation de ces unités électroniques pose un certain nombre de problèmes du fait des exigences assez nombreuses auxquelles elles doivent répondre.

Tout d'abord, une carte de paiement à microcircuits doit avoir le même format qu'une carte classique à pistes magnétiques standardisée dont la longueur est de 85 mm, la largeur de 54 mm et l'épaisseur de 0,76 mm (normes ISO) ou tout au moins des dimensions voisines pour rester peu encombrante et facilement maniable.

Si l'on se rend compte que, premièrement, une épaisseur de 760 microns ne correspond grossièrement qu'à deux fois celle d'une puce de circuit intégré sans protection, que, deuxièmement, la portion de la surface de la carte qui peut être allouée à l'unité électronique est très limitée étant donné que la majeure partie de celle-ci doit être réservée à des inscriptions telles que la dénomination du prestataire qui délivre la carte, l'identité du porteur, une signature, des informations d'utilisation et éventuellement une photo et que, troisièmement, les plages conductrices doivent être suffisamment grandes pour que le contact avec les pièces de connexion d'un appareil soit assuré et bon, on en déduit très vite que l'on ne peut pas utiliser des circuits standardisés déjà enrobés ou emboîtés comme ceux que l'on trouve actuellement sur le marché et qui sont trop volumineux.

On est donc obligé, pour fabriquer les unités électroniques, de partir de puces de circuits intégrés nues, de réaliser soi-même le réseau d'interconnexions qui permet de relier électriquement ces puces avec l'extérieur et entre elles si il y en a plusieurs dans une même unité et d'assurer la protection de l'ensemble qui est naturellement très fragile surtout au niveau des jonctions entre les pièces conductrices (bornes de connexion de la puce, fils, etc).

Cette protection doit être d'autant plus efficace que les cartes seront forcément amenées à subir très souvent des déformations qui pourront être importantes du fait que l'on demande à ces cartes, comme aux cartes classiques de répondre à des normes ou à des exigences de flexibilité relativement sévères et elle ne peut pas être assurée en donnant aux unités électroniques la plus grande rigidité possible car cela pourrait donner aux zones dans lesquelles celles-ci sont placées une certaine raideur qui empêcherait les cartes de remplir ces conditions de flexibilité.

Enfin, il est bien clair que ces unités électroniques doivent pouvoir être fabriquées en grande série et à un prix de revient très bas.

Le but de l'invention est d'apporter une solution satisfaisante à ces différents problèmes.

Il est atteint grâce au fait que dans une unité électronique selon l'invention qui comprend un support susceptible d'être soumis à des contraintes pouvant entraîner sa déformation, une puce de circuit intégré avec des bornes de connexion et un ensemble de conducteurs électriques ayant chacun une première extrémité à laquelle est fixée une borne de connexion de la puce et une seconde extrémité liée rigidement au support, la puce est montée sur une feuille souple de matériau isolant portée au moins indirectement par le support, sur laquelle est fixée au moins une portion de chacun des conducteurs et dont au moins une fraction qui comprend la zone dans laquelle se trouve la puce et une majeure partie de l'entourage de celle-ci est dépourvue de toute liaison rigide avec le support.

La feuille souple dispose ainsi d'une certaine liberté qui lui permet de ne pas suivre ou de ne suivre que partiellement les mouvements du support lorsqu'il subit effectivement des déformations, ce qui permet d'éviter au moins en grande partie que les contraintes auxquelles il est alors soumis soient transmises non seulement aux liaisons entre les bornes de la puce et les conducteurs mais aussi, comme on pourra s'en rendre compte par la suite, aux conducteurs eux-mêmes, notamment à leurs parties les plus fragiles lorsqu'ils en présentent.

D'autres caractéristiques et avantages de l'unité électronique selon l'invention apparaîtront au cours de la description qui suit de plusieurs formes possibles d'exécution sous lesquelles elle peut se présenter lorsqu'elle est plus particulièrement destinée à être incorporée dans une carte à microcircuits. Cette description sera faite en référence aux dessins annexés parmi lesquels :

- la figure 1 est une vue de dessus d'une première de ces formes de réalisation de l'unité selon l'invention;

0198376

- la figure 2 est une vue en coupe selon le plan II-II de la figure 1;

- les figures 3 et 4 montrent schématiquement comment l'unité des figures 1 et 2 peut être placée dans une carte à microcircuits; et

- les figures 5 à 12 sont des vues en coupe complètes ou partielles de huit autres de ces modes d'exécution, où les mêmes éléments que ceux des figures 1 et 2, à des différences de dimensions et de forme près, sont désignés par les mêmes repères.

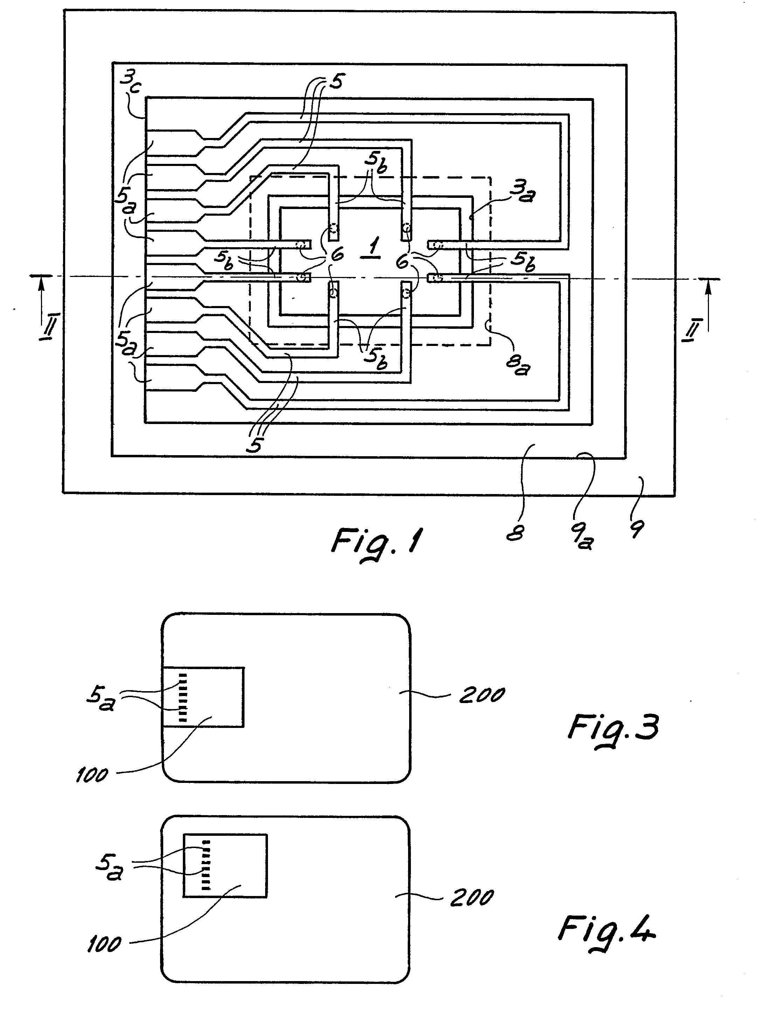

Telle qu'elle est représentée sur les figures 1 et 2, l'unité électronique selon l'invention comprend une puce de circuit intégré 1 de forme sensiblement parallélépipédique qui contient par exemple une mémoire et un microprocesseur et dont la face avant $1_a$ est munie de huit bornes de connexion 2. Comme cela a déjà été indiqué, ce nombre de bornes est celui qui est prévu généralement pour une carte de crédit mais il pourrait aussi y en avoir plus, ou moins.

Cette unité comprend également une feuille souple rectangulaire 3, formée d'un matériau électriquement isolant comme le polyester connu sous la marque "Mylar" ou le polyimide commercialisé sous la marque "Kapton" et qui présente une ouverture $3_a$ également rectangulaire, de longueur et de largeur légèrement supérieures à celles de la puce.

Cette feuille 3 porte sur sa face antérieure $3_b$, entièrement recouverte d'une fine couche 4 de matière isolante, par exemple de colle durcie, un réseau de huit bandes conductrices 5 qui, à un bout, aboutissent chacune à une plage de contact $5_a$ faite d'une seule pièce avec elle et qui, à l'autre bout, se prolongent au-dessus de l'ouverture $3_a$ pour former des pattes $5_b$ à profil droit dont les extrémités sont fixées par des liaisons conductrices 6 qui peuvent être des soudures ou des amas de colle, sur les bornes 2 de la puce.

Comme le montre la figure 2, les liaisons 6 sont noyées dans un revêtement 7 en matériau adhésif opaque et relativement dur, par exemple en silicone, qui recouvre entièrement la face avant de la puce en s'élevant à peu près jusqu'au niveau de la surface supérieure des pattes $5_b$ et qui, tout en protégeant le circuit intégré contre la lumière, empêche dans une certaine mesure les contraintes auxquelles peuvent être soumises les pattes de se répercuter au niveau de ces liaisons naturellement fragiles.

En ce qui concerne la couche intermédiaire 4 entre les bandes conductrices 5 et la feuille souple 3, elle peut par exemple être prévue pour améliorer la résistance mécanique de cette dernière ou simplement résulter d'une étape nécessaire pour la réalisation des bandes conductrices, mais elle pourrait aussi ne pas exister.

Par ailleurs, comme on pourra s'en rendre compte par la suite, les pattes $5_b$ dont l'épaisseur est évidemment très faible (une trentaine de microns environ) n'ont pas qu'un rôle électrique à jouer. Elles doivent également supporter la puce. Il est donc nécessaire qu'elles s'étendent à partir d'au moins deux côtés opposés de l'ouverture $3_a$, sinon la puce ne serait pas liée suffisamment rigidement à la feuille 3. De ce fait, les pattes $5_b$ et, malgré la présence du revêtement 7, leurs liaisons 6 avec les bornes de la puce subiraient, rien qu'à cause de cela, des contraintes qui risqueraient de provoquer leur rupture.

En fait, ce qui est préférable, c'est, comme l'illustre la figure 1, de répartir les pattes le mieux possible autour de la puce, en fonction de la position de ses bornes de connexion qui est elle-même plus ou moins conditionnée par l'architecture du circuit intégré.

A noter que, pour la même raison, il y a intérêt à ce que la distance entre la puce et la périphérie de l'ouverture de la feuille soit très faible.

Enfin, toujours à propos des conducteurs 5, on voit sur la figure 1 que toutes les plages $5_a$, qui sont naturellement destinées à recevoir les éléments de contact, par exemple les broches, des appareils dans lesquels la carte pourra être introduite, sont toutes disposées l'une à côté de l'autre, le long d'un même côté $3_c$ de la feuille 3.

Comme le montre plus clairement la vue en coupe de la figure 2, cette feuille 3 est supportée avec tous les éléments qu'elle porte elle-même par une base rectangulaire 8 de dimensions supérieures, constituée par une plaque en matière plastique et qui présente une ouverture également rectangulaire $8_a$, légèrement plus grande que

l'ouverture $3_a$ sur laquelle elle est à peu près centrée, et dans laquelle est logée la partie inférieure de la puce.

Dans ce mode d'exécution, la feuille souple 3 est effectivement fixée sur la face avant de la plaque 8, par collage ou par toute autre méthode adéquate, mais seulement par la fraction située du côté de l'ouverture $3_a$ où se trouvent les plages de contact $5_a$, le reste de la feuille restant entièrement libre vis-à-vis de la plaque. Cette fixation a été symbolisée sur le dessin par des croix.

Par ailleurs, cette plaque 8, qui a une épaisseur telle que sa face arrière et celle, $1_b$, de la puce se situent dans un même plan ou à peu près, porte également un cadre 9 en même matière et de mêmes dimensions extérieures qu'elle.

Ce cadre 9 qui est fixé rigidement sur la plaque, par exemple par collage, et qui entoure à distance la feuille souple 3 a une épaisseur sensiblement égale à la somme des épaisseurs de cette feuille, des bandes conductrices 5 et de la couche isolante 4 si elle existe, de façon que sa face avant et celles des bandes conductrices situées du côté opposé à la feuille soient sensiblement dans le même plan.

Quant à la matière qui compose la plaque 8 et le cadre 9, elle est naturellement choisie de façon que la carte à laquelle est destinée l'unité électronique puisse répondre aux exigences de flexibilité qui lui sont imposées et elle est de préférence la même que celle qui constitue le corps de cette carte qui, lui, a de fortes chances d'être en chlorure de polyvinyle souvent désigné par l'abréviation PVC.

Enfin, on a également représenté sur la figure 2, en traitillés, deux films en matière plastique 10 et 11, le premier tendu sur la face avant du cadre 9 et muni d'ouvertures $10_a$ situées chacune au droit d'une plage conductrice $5_a$, l'autre appliqué sur la face arrière de la plaque de base 5 et obturant l'ouverture $8_a$. Ces films, qui sont collés ou appliqués à chaud sur la plaque et sur le cadre, peuvent faire partie du module et être prévus par exemple pour assurer une protection temporaire de l'unité électronique entre le moment où elle est fabriquée et celui où elle est insérée dans une carte mais il peut s'agir aussi de films qui recouvrent entièrement les faces de cette dernière.

En lisant la description qui précède, on se rend très facilement compte que l'unité électronique permet bien d'atteindre le but recherché.

En effet, l'ensemble qui comprend la puce 1, la feuille souple 3 et les bandes conductrices 5 peut être facilement fabriqué en grande série et de manière entièrement automatique en utilisant la technique généralement désignée par l'abréviation T.A.B. de l'expression anglaise "tape automated bonding". En outre, il est très simple de découper la plaque de base 8 et le cadre 9 dans des feuilles de matière plastique d'épaisseurs convenables et ensuite d'assembler le tout, de préférence après avoir soumis les plages $5_a$ à un traitement galvanique pour améliorer leur résistance mécanique au contact. L'unité ne revient donc pas cher.

Par ailleurs, le nombre de liaisons fragiles entre pièces conductrices telles que soudures ou collages est limité au maximum étant donné que les bandes conductrices 5 permettent de relier directement les bornes de la puce avec l'extérieur.

D'autre part, lorsque le support formé par la plaque 8 et le cadre 9 sera soumis à des déformations la partie libre de la feuille souple 3 pourra glisser sur la plaque, éventuellement même s'en écarter par endroits si le film de protection supérieur 10 le permet, et du fait que la puce est libre dans l'ouverture $8_a$ suffisamment grande pour cela il n'y aura pratiquement aucune force qui s'exercera parallèlement à la feuille sur les pattes $5_b$ et au niveau des liaisons 6 avec les bornes de connexion sauf celles qui pourront être dues aux frottements de cette dernière sur la plaque de base, des conducteurs 5 sur le film 10 et éventuellement de la face arrière de la puce sur le film 11 si ceux-ci sont en contact, frottements que l'on cherchera évidemment à minimiser.

De plus, en regardant la figure 2, il est facile de voir que lorsque la plaque 8 sera contrainte à s'incurver vers le haut, le film de protection 10 naturellement très souple et plus ou moins élastique ne s'opposera que très peu à la tendance qu'auront la feuille 3 et les bandes conductrices 5 de rester planes, surtout si l'autre film 11 peut pousser alors la puce 1 vers le haut, et que, quand au contraire la plaque se courbera vers le bas le film 10 exercera une pression sur les conducteurs qui aidera ceux-ci et la feuille à rester plane. Par conséquent, si la feuille et les bandes conductrices sont soumises à des flexions celles-ci seront faibles et dans tous les cas les films 10 et 11 exerceront respectivement sur les pattes $5_b$ et sur la face arrière de la puce des pressions en sens contraire tendant à maintenir les extrémités de ces pattes appliquées contre les bornes de connexion 2.

Enfin, comme l'ouverture $3_a$ de la feuille 3 est plus petite que celle, $8_a$, de la plaque, la partie de la feuille qui déborde au-dessus de cette dernière pourra accompagner la flexion des pattes $5_b$ tout en réduisant l'ampleur, ce qui permet de limiter dans une très large mesure les risques de rupture des bandes conductrices au niveau du bord interne de la feuille. Evidemment, il n'en serait pas de même si l'ouverture de la feuille avait des dimensions égales ou supérieures à celles de l'ouverture de la plaque.

Les figures 3 et 4 montrent deux façons possibles d'insérer l'unité électronique qui vient d'être décrite et à laquelle on a attribué le repère 100 dans une carte de transaction. On a seulement représenté sur ces figures le contour de l'unité et la partie accessible des plages de contact $5_a$.

Sur la figure 3, l'unité se trouve dans une encoche de même forme et de mêmes dimensions prévue du côté gauche du corps 200 de la carte à peu près au milieu de celui-ci, alors que sur la figure 4 l'unité est placée de manière plus habituelle dans une ouverture située dans le coin supérieur gauche de ce corps.

Dans les deux cas, l'unité a naturellement la même épaisseur que le corps de carte dont elle a pu avoir été rendue solidaire par chassage, par collage ou de toute autre manière adéquate et ses autres dimensions sont suffisamment faibles pour laisser la place sur la ou les faces de la carte à des inscriptions telles que celles qui ont déjà été indiquées précédemment et éventuellement à des pistes magnétiques.

Selon que l'unité électronique comprend déjà ou non des films en matière plastique de protection, il est souhaitable ou nécessaire d'en prévoir au moins deux qui recouvrent entièrement chaque face de la carte à l'exception des plages de contact.

Le mode de réalisation représenté sur les figures 1 et 2 convient lorsque les éléments de connexion des appareils dans lesquels la carte est destinée à être introduite sont du type à pointes comme celui, A, qui est représenté schématiquement et partiellement sur la figure 2.

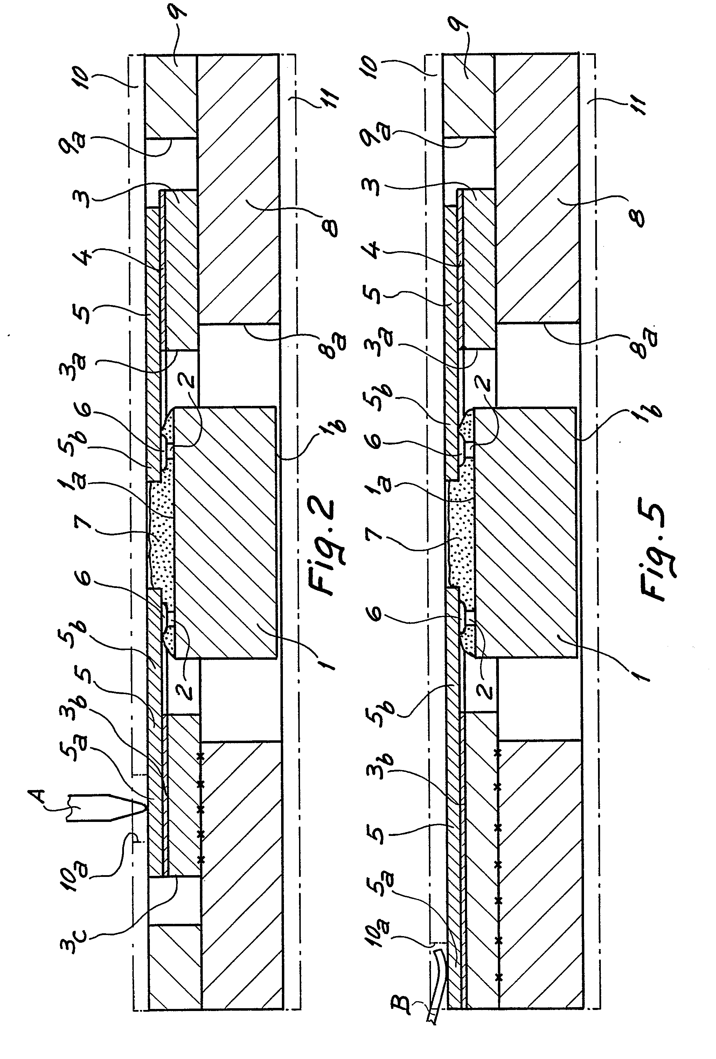

La figure 5 montre, en coupe semblable à celle de la figure 2, une forme d'exécution de l'unité électronique selon l'invention prévue pour des éléments de connexion du genre glissants tel que celui, B, qui est schématisé sur la figure.

Les seules différences entre cette forme d'exécution et la précédente sont que le cadre 9 est en forme de U et ouvert du côté où se trouvent les plages de contact $5_a$, que, de ce côté, le bord de la feuille souple 9 est aligné avec celui de la plaque et enfin que les ouvertures $10_a$ (voir figure 2) du film 10 se sont, de ce fait, transformées en encoches.

Bien entendu, dans ce cas, l'unité électronique doit être placée le long du bord de la carte, par exemple à la place qu'elle occupe sur la figure 3.

Comme on l'a montré, dans le mode d'exécution des figures 1 et 2, les déformations auxquelles sont soumis la feuille 3 et conducteurs 5 suite à celle que subit le support 8, 9 sont faibles, de même que les contraintes qui sont imposées aux pattes $5_b$ et à leurs liaisons 6 avec les bornes 2 de la puce.

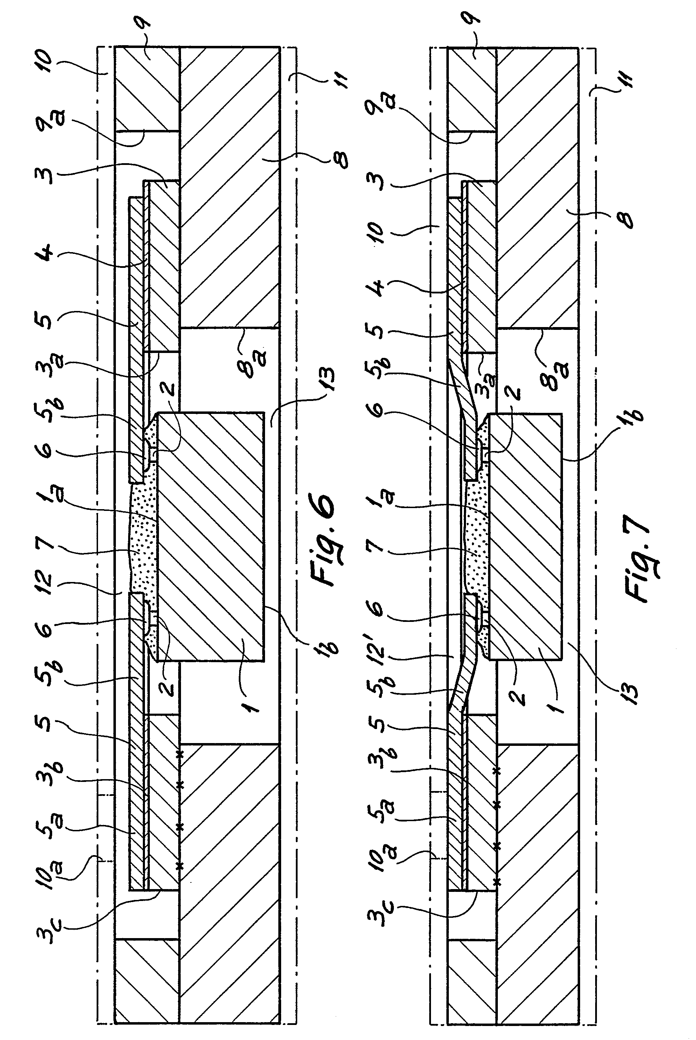

Une solution simple pour réduire encore davantage ces contraintes que peuvent subir les pattes et les supprimer pratiquement totalement pour les liaisons, c'est, comme le montre la figure 6, de donner à la plaque de base 8 et au cadre 9 des épaisseurs qui permettent de laisser un espace 12 entre les bandes conductrices 5 et le film de protection 10 et un autre, 13, entre le film 11 et la face arrière $1_b$ de la puce 1.

Grâce à cela, la partie libre de la feuille 3 peut non seulement glisser sur la plaque 8 mais aussi s'en écarter à volonté et la puce est entièrement libre de suivre ces mouvements.

Naturellement, les épaisseurs de la plaque et du cadre sont choisies en fonction des exigences de flexibilité qui sont imposées pour la carte de manière que la feuille avec les bandes conductrices 5 et la puce ne puissent pratiquement jamais venir toucher respectivement les films 10 et 11, tout au moins tant que la carte n'est pas soumise à des déformations plus importantes que celles qui correspondent à ces exigences.

De cette façon, les liaisons 6 ne seront pas soumises à d'autres contraintes que celles dues au poids de la puce et seules les pattes $5_b$ situées du côté où la feuille est fixée sur la plaque de base pourront parfois subir une légère déformation.

De plus, étant donné que la puce n'a plus sa face arrière en contact ou quasiment avec le film 11, elle est mieux protégée.

La figure 7 montre une solution intermédiaire entre celle de la figure 2 et celle de la figure 6.

Dans ce mode d'exécution, le cadre 9 a, comme dans le premier qui a été décrit, une épaisseur sensiblement égale à la somme de celles de la feuille 3, des bandes conductrices 5 et éventuellement de la couche isolante 4 qui recouvre la feuille mais les pattes $5_b$ ont été pliées pour présenter un profil en Z, de façon que leurs extrémités fixées aux bornes 2 de la puce se trouvent à l'intérieur de l'ouverture $8_a$ de la feuille et qu'il reste un espace libre 12' entre une partie au moins de ces pattes et le film 10.

Par ailleurs, l'espace 13 entre la puce et le film 11 que l'on trouve dans l'exemple de réalisation de la figure 6 existe également ici.

Dans ce cas, les pattes $5_b$ seront amenées à subir de faibles contraintes, dans la zone proche du bord de l'ouverture $3_a$ de la feuille, mais pas les liaisons 6, et ces contraintes peuvent être minimisées en s'arrangeant pour que le premier coude des pattes $5_b$, c'est-à-dire celui qui est le plus éloigné des bornes de la puce, se trouve sensiblement au niveau de la périphérie de l'ouverture $3_a$ de la feuille.

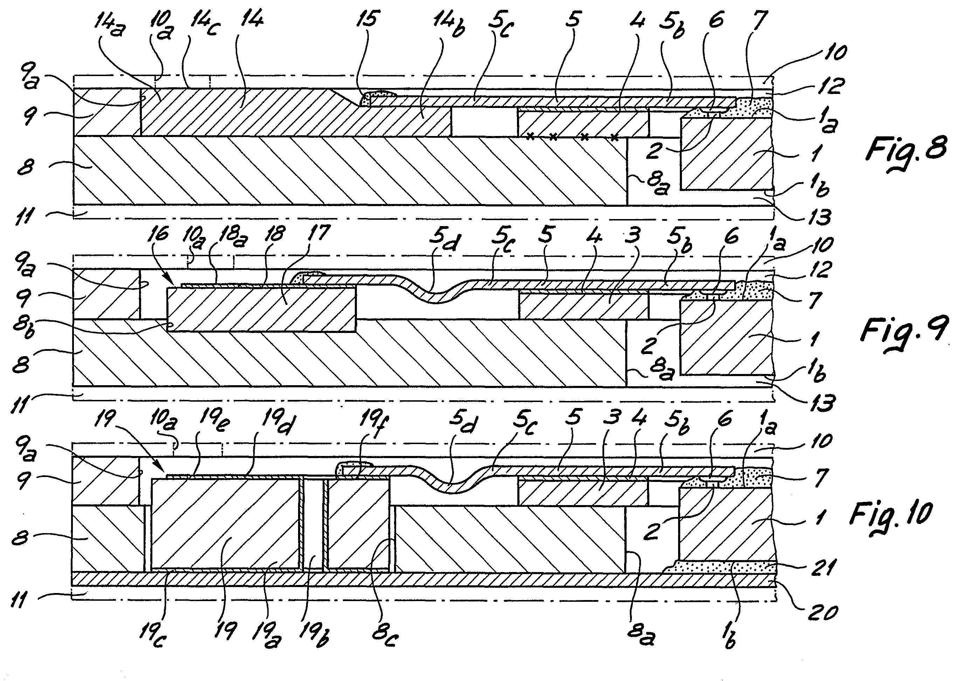

Les trois formes d'exécution de l'unité selon l'invention qui vont être décrites maintenant sont obtenues en apportant simplement à celle de la figure 6 un certain nombre de modifications. C'est la raison pour laquelle on n'a pas représenté sur les figures 8 à 10 l'unité en entier, mais seulement la partie qui permet de mettre en évidence ces changements et que l'on se contentera d'indiquer les différences qui existent entre ces formes d'exécution et celles de la figure 6 ou même seulement entre elles car certaines modifications sont communes aux trois.

La figure 8 montre une solution qui pourrait être utilisée s'il s'avêrait que, pour certains usages de la carte que l'unité électronique doit équiper et même après avoir subi un traitement galvanique, les plages de contact placées sur la feuille souple dont il a été question jusqu'à présent n'offrent pas une résistance mécanique au contact suffisante pour être fiables.

Dans ce mode de réalisation, les plages $5_a$ sont supprimées et les bandes conductrices 5 se prolongent au-delà du bord extérieur de la feuille souple 3, tout en conservant un profil droit, pour former des pattes $5_c$ sensiblement parallèles entre elles et que l'on qualifiera d'extérieures par opposition aux pattes $5_b$ qui elles peuvent être dites "intérieures".

D'autre part, l'unité comprend huit lames métalliques 14 d'épaisseur sensiblement égale à la largeur des bandes conductrices 5, qui avaient à l'origine la forme d'un rectangle de largeur égale à la hauteur du cadre 9 mais qui ont été découpées dans un coin de façon à présenter une partie large $14_a$ et une partie étroite $14_b$ de largeur sensiblement égale à l'épaisseur de la feuille souple 3, plus éventuellement celle de la couche isolante 4, et qui sont chacune prises rigidement en sandwich entre deux plaques de matériau isolant de même forme qu'elles, de manière à constituer un bloc de structure semblable à celle des connecteurs connus sous la marque "Zebra".

Ce bloc dont la figure 8 ne montre que l'une des lames 14, mais que l'on peut très facilement se représenter en esprit, est fixé par collage sur la plaque de base 8 et éventuellement au cadre 9 contre la paroi interne duquel il est appliqué, de façon que les parties étroites $14_b$ des lames 14 qui sont naturellement perpendiculaires à la plaque 8 se trouvent sous les extrémités des pattes extérieures $5_c$ et ces extrémités sont fixées sur la tranche des lames par des soudures ou par des amas de colle conductrice 15.

Dans ce cas, une ouverture $10_a$ du film de protection 10 est placée au-dessus de la partie $14_a$ de chaque lame avec laquelle il est en contact et ce sont donc des portions de tranches $14_c$ de ces lames qui servent de plages pour la liaison avec l'extérieur.

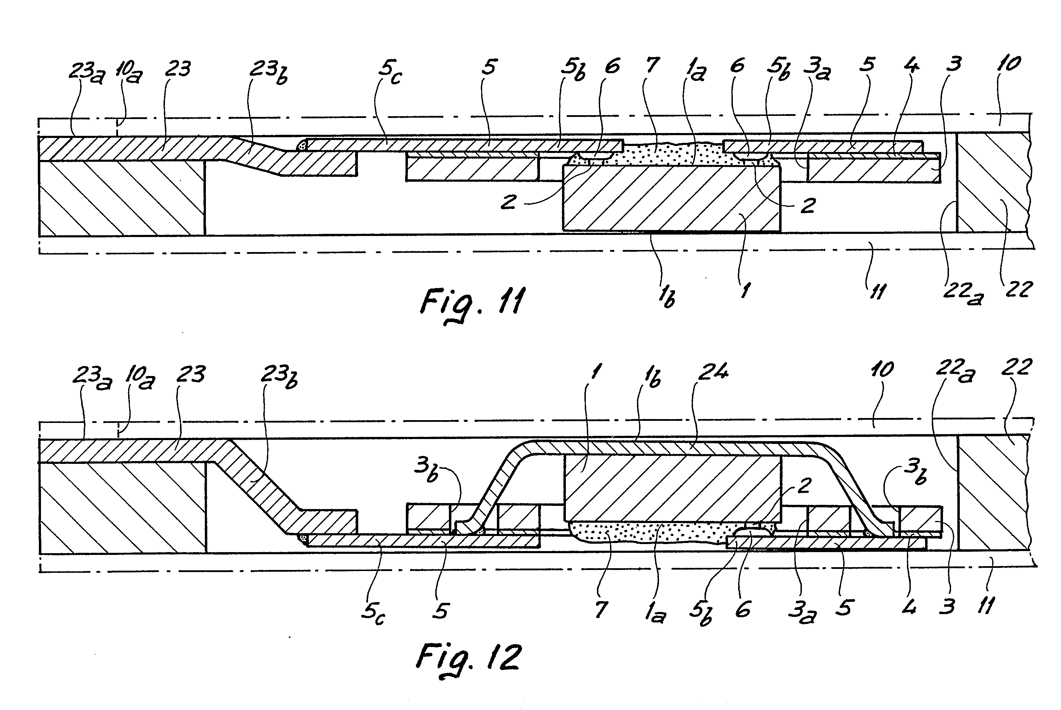

Le mode d'exécution de la figure 9 se distingue de celui de la figure 8 par le fait que, premièrement, la feuille isolante 3 n'est plus du tout fixée à la plaque de base 8, deuxièmement, les pattes extérieures $5_c$ n'ont plus un profil droit mais une partie pliée en U et, troisièmement, le bloc formé de lames conductrices et de plaques isolantes est remplacé par une plaquette de circuit imprimé 17 rectangulaire avec un réseau de pistes conductrices 18 isolées les unes des autres sur lesquelles sont fixées, à un bout, les extrémités des pattes externes $5_c$ et qui, à l'autre bout, se terminent par des plages de contact $18_a$ placées les unes à côté des autres dans la direction perpendiculaire à la figure, sous les ouvertures $10_a$ du film de protection 10. Selon son épaisseur, la plaquette 17 peut être simplement collée sur la plaque de base 8 ou encastrée partiellement et collée dans un logement $8_b$ que présente cette plaque.

On peut être amené à choisir ce mode d'exécution pour des raisons différentes.

Tout d'abord parce qu'il permet de supprimer pratiquement totalement les contraintes auxquelles pouvaient encore être soumises certaines pattes intérieures $5_b$ dans le cas de l'unité de la figure 6, car ici ce n'est plus seulement une fraction de la feuille 3 entourant la majeure partie de la périphérie de la puce qui peut glisser sur la plaque 8 et s'en écarter mais la totalité, ceci grâce notamment à la présence des pliures $5_d$ qui, en plus, font que les pattes extérieures $5_c$ et leurs fixations sur les pistes 18 du circuit imprimé ne risquent pas beaucoup de souffrir de ces mouvements de la feuille.

Il est également possible de faire appel à cette solution lorsque l'unité doit présenter des plages de contact de dimensions particulièrement grandes et lorsque l'on n'a pas intérêt à augmenter la surface de la feuille souple en conséquence, par exemple à cause du coût assez élevé des matériaux comme le "Kapton" ou parce qu'il ne serait pas rentable de prévoir un outillage spécial pour fabriquer des unités de ce genre.

Il en serait de même s'il fallait augmenter non pas la grandeur des plages de contact mais leur nombre.

Enfin, il est intéressant de noter que si, au lieu de rapporter la partie droite de la figure 6 pour compléter la figure 9, on effectuait tout simplement une symétrie, on obtiendrait alors la représentation d'une unité avec des plages de contact de chaque côté de la puce, comme cela se fait généralement dans les cartes de paiement déjà existantes. Evidemment, si l'on réalisait une telle unité, le réseau de bandes conductrices sur la feuille 3 aurait une configuration différente et, dans l'exemple que l'on a choisi où la puce comporte huit bornes de connexion, il n'y aurait que quatre plages de contact $18_a$ et quatre pattes extérieures $5_c$ de chaque côté.

La figure 10 montre un mode de réalisation qui peut convenir lorsque le substrat du circuit intégré doit être relié à la masse, cette liaison se faisant par la face arrière de la puce.

Comme dans le précédent, la feuille isolante 3 est libre par rapport à la plaque de base 8 et les pattes extérieures $5_c$ présentent des pliures en U mais le circuit imprimé simple 17 de la figure 9 est remplacé par un circuit imprimé double face 19 logé dans une seconde ouverture $8_c$ que présente la plaque $8_a$. Ce circuit imprimé 19 se compose d'une plaquette isolante $19_a$ percée d'un trou $19_b$, de huit pistes conductrices $19_f$ avec des plages respectives, qui sont toutes sur la face avant de la plaquette et sur lesquelles sont fixées les extrémités des pattes $5_c$, et d'une métallisation $19_c$ qui recouvre entièrement la face arrière de la plaquette et la paroi du trou $19_b$ mais qui, sur la face avant de cette plaquette, ne forme plus qu'une piste conductrice $19_d$ qui rejoint celle des huit autres pistes qui est reliée à la borne de masse du circuit intégré ou directement la plage de contact $19_e$ correspondante.

Par ailleurs, la liaison électrique entre la métallisation 19c et la face arrière de la puce est assurée par une mince feuille métallique 20 à laquelle est fixé le circuit imprimé 19, au moyen d'une colle conductrice, et qui recouvre entièrement la face arrière de la plaque de base 8 dont elle est solidaire et par une couche de colle conductrice 21 qui adhère à la fois à la feuille 20 et à la face arrière $1_b$ de la puce, cette feuille étant recouverte à son tour par le film de protection 11.

Dans cette forme particulière d'exécution, la puce 1 est donc pratiquement fixe par rapport au support mais étant donné que la feuille isolante 3 toute entière peut se déplacer, les pattes intérieures $5_b$ et leurs liaisons 6 avec les bornes de connexion 2 de la puce ne subiront que des contraintes comparables à celles à laquelle elles peuvent être soumises dans le cas du mode de réalisation des figures 1 et 2.

Dans le mode d'exécution représenté à la figure 11, le support n'est plus constitué par une plaque de base et un cadre mais par une plaque simple 22 dont l'épaisseur est égale ou à peine supérieure à la hauteur de l'ensemble comprenant la puce 1, la feuille souple 3 et les bandes conductrices 5 et qui présente une ouverture rectangulaire $22_a$ plus grande que la feuille dans laquelle cet ensemble est logé entièrement. D'autre part, les bandes conductrices 5 forment au-delà du bord de la feuille 3 des pattes externes $5_c$ à profil droit dont les extrémités sont soudées ou collées respectivement sur des pattes à profil en Z $23_b$ formées dans l'ouverture $22_a$ par d'autres bandes conductrices 23, plus épaisses, qui aboutissent à des plages de contact $23_a$ et qui sont fixées sur la plaque 22, cette dernière présentant un évidement ou plusieurs gorges pour les recevoir.

On est donc ici dans le cas où la feuille 3 est portée par le support non pas directement mais par l'intermédiaire des conducteurs qui relient les plages de contact aux bornes de la puce et qui ne sont plus homogènes mais formés chacun d'une bande conductrice 5 et d'une bande conductrice 23.

Dans ce mode de réalisation, plusieurs des avantages de ceux qui précèdent sont rassemblés. L'épaisseur de l'unité est réduite au minimum, les plages de contact peuvent présenter une bonne résistance mécanique et être grandes sans que la feuille souple le soit aussi et les contraintes subies en cas de déformation de la plaque par les pattes internes et externes des bandes conductrices 5 et leurs liaisons avec, respectivement, les bornes de la puce et les bandes conductrices 23 ne peuvent être que très faibles car elles sont dues seulement à des pressions exercées par les films de protection 10 et 11.

Naturellement, on pourrait aussi imaginer de supprimer les bandes conductrices 23 et de prolonger celles qui sont portées par la feuille 3 mais à condition que ces dernières soient suffisamment résistantes pour ne pas risquer de se rompre en particulier au niveau du bord de l'ouverture $22_a$ de la plaque.

Le mode d'exécution de la figure 12 qui, comme celui de la figure 10 est prévu pour le cas où le substrat du circuit intégré doit être relié à la masse de ce dernier, ne présente que deux différences avec le précédent.

La première est que l'ensemble qui comprend la puce, la feuille et les bandes conductrices 5 est placé de façon que la face arrière $1_b$ de la puce se trouve du même côté du support que les plages de contact $23_a$ mais il aurait très bien pu l'être comme sur la figure 11, l'inverse étant également vrai.

La seconde est que cet ensemble est muni d'une bande conductrice supplémentaire 24 en forme de U dont la base est en contact direct avec la face arrière de la puce ou liée à celle-ci par une couche de colle conductrice et dont les branches latérales passent dans deux trous $3_b$ de la feuille souple 3 pour avoir leurs extrémités soudées ou collées sous la bande métallique 5 dont la patte interne $5_b$ est fixée sur la borne de masse de la puce.

Cette bande supplémentaire qui constitue aussi en quelque sorte un anneau de garde pour la protection du point de vue électrostatique du circuit peut être par exemple aussi mince que les bandes 5 pour éviter que sa présence soit la cause d'une augmentation notable de l'épaisseur de l'unité. Quant à sa largeur, elle peut aller de celle des bandes 5 et même moins à la longueur ou la largeur de la puce selon le sens dans lequel elle est placée.

Dans certaines variantes, elle pourrait être remplacée par une bande en forme de L ou par un fil qui n'irait pas forcément d'un bout à l'autre de la puce et qui, si l'on voulait éviter de prévoir un trou spécial dans la feuille, pourrait avoir son extrémité fixée en un point situé sur la patte externe $5_c$ de la bande 5 reliée à la masse du circuit ou même sur la patte $23_b$ de la bande 23 associée à celle-ci.

Il est bien clair que, sans sortir du cadre de l'invention, on pourrait trouver beaucoup d'autres formes possibles de réalisation pour l'unité selon l'invention et de nombreuses variantes pour celles qui ont été décrites, d'autant plus que, comme on l'a déjà dit, elle peut être utile dans d'autres domaines que celui des cartes à microcircuits.

Par exemple il n'est pas nécessaire que le support, son ouverture ou ses ouvertures, la feuille souple, son ouverture, etc., ait une forme rectangulaire. L'unité pourrait aussi avoir une forme circulaire et même ne pas être plane mais par exemple, semi-cylindrique pour certaines applications.

D'autre part, on pourrait, en même temps que l'on recouvre la face avant de la puce de matériau adhésif opaque, combler l'espace entre la puce et la périphérie de l'ouverture de la feuille souple avec ce même matériau pour soulager les pattes internes, ou sans faire cela remplir l'espace qui entoure la puce et, lorsqu'il existe, celui qui se trouve au-dessous de celle-ci d'un matériau adhésif isolant et suffisamment mou, comme le sont certains silicones, pour ne gêner que très peu la puce dans ses mouvements ce qui présenterait le même avantage et, en plus, assurerait une meilleure protection de la puce.

Il serait également tout à fait possible que la feuille souple ne porte pas une seule puce de circuit intégré mais deux ou plus, montées de la même façon qui seraient connectées entre elles et dont une au moins serait reliée à des plages de contact.

A propos de cette feuille, on a indiqué les raisons pour lesquelles il est préférable lorsqu'elle est portée directement par une plaque de base qu'elle déborde au-dessus de l'ouverture de celle-ci mais ceci n'est tout de même pas une obligation.

On a aussi laissé entendre qu'il y a avait intérêt, pour des questions de résistance mécanique et de fiabilité, à ce que les conducteurs qui relient la puce à l'extérieur, ou, s'il y en a plusieurs, au moins une puce à l'extérieur et les puces entre elles, soient le moins hétégorènes possible afin de limiter au maximum le nombre de points de soudure ou de collage. Toutefois, cela ne veut pas dire que l'on ne pourrait pas remplacer chacune des bandes conductrices liées à la feuille souple, dont il a été question dans la description, par une piste conductrice sur la feuille souple, une patte ou un fil soudé ou collé d'un côté sur la piste et de l'autre sur une borne de la puce.

Par contre, ce qui ne présenterait aucun désavantage, ce serait de substituer à la plaque de base et au cadre lorsqu'ils existent un support homogène en même matériau réalisé par exemple par emboutissage.

Par ailleurs, il n'est pas indispensable que la feuille souple ait une ouverture. Elle pourrait être pleine et porter des pistes conductrices sur lesquelles seraient fixées les bornes de la puce. Dans ce cas, il faudrait évidemment, pour atteindre le but recherché, que la zone de la feuille située sous la puce et au moins une majeure partie de l'entourage de celle-ci ne soient pas liées rigidement au support.

Enfin, il est utile de souligner que l'on ne sortirait pas non plus du cadre de l'invention si le support ne formait qu'une seule pièce avec le corps de carte.

REVENDICATIONS

1.  Unité électronique comprenant un support susceptible d'être soumis à des contraintes pouvant entraîner sa déformation, une puce de circuit intégré présentant une face avant munie de bornes de connexion et une face arrière, et un ensemble de conducteurs électriques ayant chacun une première extrémité à laquelle est fixée par une liaison conductrice une borne de connexion de la puce et une seconde extrémité liée rigidement au support, caractérisée par le fait que la puce (1) est montée sur une feuille souple de matériau isolant (3) portée au moins indirectement par le support (8, 9; 22), sur laquelle est fixée au moins une portion de chacun desdits conducteurs (5; 5, 23) et dont au moins une fraction qui comprend la zone dans laquelle se trouve ladite puce et une majeure partie de l'entourage de celle-ci est dépourvue de toute liaison rigide avec ledit support.

2.  Unité électronique selon la revendication 1, caractérisée par le fait que la feuille souple (3) repose sur le support (8, 9).

3.  Unité électronique selon la revendication 2, caractérisée par le fait que les secondes extrémités des conducteurs (5) se trouvent toutes d'un même côté de la puce (1) et qu'une fraction de la feuille souple (3) située de ce côté de la puce est liée rigidement au support (8, 9).

4.  Unité électronique selon la revendication 3, caractérisée par le fait que les secondes extrémités des conducteurs (5) se trouvent sur la fraction de la feuille (3) qui est liée rigidement au support (8, 9) et font partie des portions de conducteurs qui sont fixées sur ladite feuille.

5.  Unité électronique selon la revendication 2, caractérisée par le fait que les secondes extrémités des conducteurs (5) sont situées en dehors de la feuille (3), que la totalité de la feuille est dépourvue de toute liaison rigide avec le support (8, 9) et que les conducteurs présentent des pliures ($5_d$) entre leurs secondes extrémités et ladite feuille.

6.  Unité électronique selon la revendication 5, caractérisée par le fait que la puce (1) est solidaire du support (8, 9) et est liée à la feuille par des portions libres ($5_b$) des conducteurs (5).

19    0198376

7. Unité électronique selon la revendication 1, caractérisée par le fait que les secondes extrémités des conducteurs (5, 23) sont situées en dehors de la feuille (3) et que ladite feuille est portée par le support (22) par l'intermédiaire desdits conducteurs.

8. Unité électronique selon la revendication 2, prévue pour être utilisée dans une carte à microcircuits et présentant des plages de contact fixes par rapport au support, reliées respectivement aux secondes extrémités des conducteurs et accessibles pour un appareil dans lequel la carte est destinée à être introduite, caractérisée par le fait que la feuille souple (3) présente une ouverture ($3_a$) dont la périphérie entoure les bornes de connexion (2) de la puce (1); que les conducteurs (5) se prolongent sous forme de pattes intérieures ($5_b$), en direction de la puce, au-delà de la périphérie de l'ouverture de la feuille, pour avoir chacun leur première extrémité fixée sur une des bornes de connexion de la puce; que le support comprend une base (8) sensiblement plane avec une face avant sur laquelle est placée la feuille et une face arrière sensiblement parallèle aux faces avant ($1_a$) et arrière ($1_b$) de la puce et munie d'une ouverture ($8_a$) située au-dessous de celle de la feuille, dont la périphérie entoure à distance ladite puce, et un cadre (9) lié rigidement à la base qui présente une face avant sensiblement plane et parallèle à la base du côté opposé à cette dernière et qui entoure au moins partiellement et à distance la feuille et les conducteurs; et que ladite base et ledit cadre ont des épaisseurs telles que la puce, la feuille et les conducteurs soient logés entièrement dans l'espace compris entre les plans dans lesquels sont situées la face avant du cadre et la face arrière de la base.

9. Unité électronique selon la revendication 8, caractérisée par le fait que les secondes extrémités des conducteurs (5) se trouvent toutes d'un même côté de la puce (1) et qu'une fraction de la feuille souple (3) située de ce côté de la puce est liée rigidement à la base (8).

10. Unité électronique selon la revendication 9, caractérisée par le fait que les plages de contact ($5_a$) se trouvent sur la fraction de la feuille (3) qui est liée rigidement à ladite base (8) et que, entre ces plages de contact auxquelles ils aboutissent directement et la périphérie de l'ouverture ($3_a$) de la feuille, les conducteurs (5) sont entièrement fixés sur ladite feuille.

11. Unité électronique selon la revendication 10, caractérisée par le fait que les conducteurs (5) sont constitués par des bandes métalliques homogènes faites d'une seule pièce avec les plages de contact ($5_a$).

12. Unité électronique selon la revendication 11, caractérisée par le fait que la face des bandes conductrices (5) située du côté opposé à la feuille souple (3) se trouve sensiblement dans le même plan que la face avant du cadre (9).

13. Unité électronique selon la revendication 12, caractérisée par le fait que la base (8) du support a une épaisseur telle que la face arrière ($1_b$) de la puce (1) se trouve sensiblement dans le même plan que celle de ladite base.

14. Unité électronique selon la revendication 12, caractérisée par le fait que la base (8) du support a une épaisseur telle qu'il existe un espace (13) entre la face arrière ($1_b$) de la puce (1) et le plan dans lequel est située celle de ladite base.

15. Unité électronique selon la revendication 11, caractérisée par le fait que la base (8) et le cadre (9) du support ont des épaisseurs telles qu'il existe des espaces (12, 13) respectivement entre la face des bandes conductrices (5) située du côté opposé à la feuille souple (3) et le plan dans lequel se trouve la face avant dudit cadre et entre la face arrière ($1_b$) de la puce et le plan dans lequel est située celle de ladite base.

16. Unité électronique selon l'une des revendications 12 à 15, caractérisée par le fait que les pattes intérieures ($5_b$) gardent un profil droit au-dessus de l'ouverture ($3_a$) de la feuille souple (3).

17. Unité électronique selon la revendication 13, caractérisée par le fait que les pattes intérieures ($5_b$) sont pliées de façon que les premières extrémités des bandes conductrices (5) soient écartées du plan dans lequel est située la face avant du cadre (9).

18. Unité électronique selon l'une des revendications 8 à 17, caractérisée par le fait que la feuille souple (3) ainsi que la base (8) et le cadre (9) du support sont de forme rectangulaire, que ledit cadre a un bord extérieur qui coïncide avec celui de ladite base et que les plages de contact ($5_a$) sont disposées l'une à côté de l'autre le long d'un côté ($3_c$) de ladite feuille.

0198376

19. Unité électronique selon la revendication 18, caractérisée par le fait que le cadre (9) entoure totalement la feuille souple (3).

20. Unité électronique selon la revendication 18, caractérisée par le fait que le côté ($3_c$) de la feuille (3) le long duquel sont disposées les plages de contact ($5_a$) coïncide sensiblement avec le bord de la base (8) et que le cadre (9) est disposé autour des trois autres côtés de ladite feuille.

21. Unité électronique selon la revendication 9, caractérisée par le fait qu'elle comporte également une pluralité de lames métalliques (14) en nombre égal à celui des conducteurs (5), disposées sensiblement perpendiculairement à la base (8) et séparées l'une de l'autre par des plaques de matière isolante dont elles sont solidaires, l'ensemble formé par ces lames et ces plaques étant fixé sur la face avant de la base; que lesdits conducteurs se prolongent sous forme de pattes externes ($5_c$) au-delà de la feuille souple (3) pour avoir leurs secondes extrémités fixées respectivement sur des parties de la tranche des lames situées du côté opposé à ladite base; et que d'autres parties ($14_c$) de la tranche de ces lames forment lesdites plages de contact.

22. Unité électronique selon la revendication 8, caractérisée par le fait qu'elle comporte également une plaquette en matière électriquement isolante (17; $19_a$) liée rigidement à la base (8) du support avec une face avant sur laquelle sont fixées les plages de contact ($18_a$; $19_e$) et un ensemble de pistes conductrices (18; $19_d$, $19_f$) aboutissant chacune à l'une de ces plages et une face arrière; que les conducteurs (5) se prolongent au-delà de la feuille souple (3), sous forme de pattes externes ($5_c$), pour avoir leurs secondes extrémités fixées respectivement sur lesdites pistes conductrices; que la totalité de ladite feuille est dépourvue de toute liaison avec ladite base; et que lesdites pattes externes présentent des pliures ($5_d$).

23. Unité électronique selon la revendication 22, caractérisée par le fait que la plaquette (17) est fixée sur la face avant de la base (8) du support.

24. Unité électronique selon la revendication 22, caractérisée par le fait que la plaquette ($19_a$) porte sur sa face arrière une

couche métallique ($19_c$) reliée électriquement à l'une desdites plages de contact ($19_e$) et est logée dans une ouverture supplémentaire ($8_c$) que présente la base (8) du support de façon que la couche métallique se trouve sensiblement dans le même plan que la face arrière de la base, et que ladite unité comporte en plus une feuille métallique (20) qui recouvre ladite face arrière de la base dont elle est solidaire, qui est en contact électrique avec ladite couche métallique et qui est reliée électriquement à la face arrière ($1_b$) de la puce (1) par une couche de colle conductrice (21).

25. Unité électronique selon l'une des revendications 8 à 24, caractérisée par le fait que l'ouverture ($3_a$) de la feuille souple (3) est plus petite que celle ($8_a$) de la base (8) du support afin que ladite feuille déborde au-dessus de cette dernière.

26. Unité électronque selon l'une des revendications 8 à 25, caractérisée par le fait que la base (8) et le cadre (9) sont deux pièces assemblées.

27. Unité électronique selon la revendication 26, caractérisée par le fait que le cadre (9) est collé sur la base (8).

28. Unité électronique selon l'une des revendications 8 à 25, caractérisée par le fait que le cadre (9) est fait d'une seule pièce avec la base (8).

29. Unité électronique selon la revendication 7, prévue pour être utilisée dans une carte à microcircuits et présentant des plages de contact fixes par rapport au support, reliées respectivement aux secondes extrémités des conducteurs et accessibles pour un appareil dans lequel la carte est destinée à être introduite, caractérisée par le fait que le support est constitué par une plaque (22) sensiblement plane, munie d'une ouverture ($22_a$) plus grande que la feuille (3) et dont l'épaisseur est suffisante pour que la puce (1), la feuille et les parties des conducteurs (5, 23) qui ne sont pas liées rigidement à ladite plaque puissent être logées entièrement dans ladite ouverture.

30. Unité électronique selon la revendication 29, caractérisée par le fait que la feuille (3) présente une ouverture ($3_a$) dont la périphérie entoure les bornes de connexion (2) de la puce (1) et que les conducteurs (5, 23) se prolongent sous forme de pattes intérieures ($5_b$), en direction de la puce, au-delà de la périphérie de ladite ouverture de la feuille, pour avoir chacun leur première extrémité fixée sur une des bornes de ladite puce.

31. Unité électronique selon la revendication 30, caractérisée par le fait que chaque conducteur comprend une première bande métallique (5) sensiblement plane, qui est fixée sur la feuille (3), qui forme l'une desdites pattes intérieures ($5_b$) et qui se prolonge également au-delà du bord extérieur de ladite feuille pour former une patte externe ($5_c$), et une seconde bande métallique (23) plus épaisse, fixée sur la plaque (22), qui se prolonge au-delà de la périphérie de l'ouverture ($22_a$) de ladite plaque sous forme d'une patte ($23_b$) à l'extrémité de laquelle est fixée celle de la patte externe de ladite première bande.

32. Unité électronique selon la revendication 31, caractérisée par le fait que les pattes ($23_b$) des secondes bandes métalliques (23) sont pliées de façon à pénétrer dans l'ouverture ($22_a$) de la plaque (22) et que ladite plaque a une épaisseur sensiblement égale à la hauteur de l'ensemble qui comprend la puce (1), la feuille (3) et les premières bandes métalliques (5).

33. Unité électronique selon la revendication 31, caractérisée par le fait qu'elle comprend également une bande métallique supplémentaire (24) qui relie électriquement la face arrière de la puce (1) à la première bande métallique (5) qui est reliée à la borne de masse de ladite puce.

34. Unité électronique selon la revendication 33, caractérisée par le fait que la bande métallique supplémentaire (24) a la forme d'un U dont la base est en contact électrique avec la puce (1) et dont les branches latérales passent dans deux trous ($3_b$) de la feuille (3) pour avoir leurs extrémités fixées sous ladite première bande métallique (5) qui est reliée à la borne de masse de la puce.

35. Unité électronique selon la revendication 34, caractérisée par le fait que les pattes ($23_b$) des secondes bandes métalliques (23) sont pliées de façon à pénétrer dans l'ouverture ($22_a$) de la plaque (22) et que ladite plaque a une épaisseur sensiblement égale à la hauteur de l'ensemble qui comprend la puce (1), la feuille (3), les premières bandes métalliques (5) et la bande métallique supplémentaire (24).

36. Unité électronique selon l'une des revendications 31 à 35,

0198376

caractérisée par le fait que la feuille (3) est sensiblement rectangulaire et que toutes les pattes externes ($5_c$) desdites premières bandes métalliques (5) se trouvent d'un même côté de ladite feuille.

37. Unité électronique selon l'une des revendications 8 à 36, caractérisée par le fait que les liaisons conductrices entre les bornes de connexion (2) de la puce (1) et les premières extrémités des conducteurs (5; 5, 23) sont constituées par des soudures (6).

38. Unité électronique selon l'une des revendications 8 à 37, caractérisée par le fait que les liaisons conductrices entre les bornes de connexion (2) de la puce (1) et les premières extrémités des conducteurs (5) sont noyées dans un revêtement (7) de matériau adhésif dur et opaque qui recouvre entièrement la face avant ($1_a$) de la puce.

39. Unité électronique selon l'une des revendications 8 à 38, caractérisée par le fait que la feuille souple (3) est recouverte d'une couche intermédiaire (4) de matière adhésive placée sous les conducteurs (5; 5, 23).

40. Unité électronique selon l'une des revendications 8 à 39, caractérisée par le fait qu'elle comprend en plus deux films de protection (10, 11) en matière plastique fixés respectivement à l'avant et à l'arrière du support (8, 9), le film (10) placé à l'avant étant découpé au droit des plages de contact ($5_a$; $14_c$; $18_a$; $19_e$; $23_a$).

41. Unité électronique selon l'une des revendications 8 à 40, caractérisée par le fait que le support (8, 9; 22) est en matière plastique.

42. Unité électronique selon la revendication 41, caractérisée par le fait que le support (8, 9; 22) est en chlorure de polyvinyle.

43. Carte à microcircuits caractérisée par le fait qu'elle comprend une unité électronique selon l'une des revendications 8 à 42.

44. Carte à microcircuits comprenant un corps en matière plastique et une unité électronique selon la revendication 41 ou 42, caractérisée par le fait que ledit corps constitue ledit support (8, 9; 22).

Fig. 1

Fig. 3

Fig. 4

Fig.2

Fig.5

Fig.6

Fig.7

0198376

Fig.8

Fig.9

Fig.10

4/5

0198376

Fig. 11

Fig. 12

Office européen
des brevets

**RAPPORT DE RECHERCHE EUROPEENNE**

0198376
Numéro de la demande

EP  86 10 4689

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | FR-A-2 337 381  (HONEYWELL BULL)<br>*  Figures  4,6;  revendications 1,2,6,29 * | 1 | H 01 L   23/48<br>G 06 K   19/06 |
| A | | 2,4,6,<br>8,10,<br>11,24,<br>37,38,<br>41,43,<br>44 | |
| | --- | | |
| A | FR-A-2 438 339  (SOCIETE SUISSE)<br>* Revendications 1,2,5,6; page 2, lignes 18-23 * | 1,5 | |
| | --- | | |
| A | FR-A-2 523 335  (FLONIC)<br>* Revendication 1; figure 2 * | 1 | DOMAINES TECHNIQUES RECHERCHES (Int. Cl.4) |
| | --- | | |
| A | EP-A-0 116 117  (ABBOTT)<br>* Figures 2,4 * | 3 | H 01 L<br>G 06 K |
| | ----- | | |

Le présent rapport de recherche a été établi pour toutes les revendications

| Lieu de la recherche<br>LA HAYE | Date d'achèvement de la recherche<br>03-07-1986 | Examinateur<br>DE RAEVE R.A.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille. document correspondant

OEB Form 1503 03 82